# FASCICULE DE BREVET EUROPEEN

(11) **EP 4 386 850 B1**
(45) Date de publication et mention de la délivrance du brevet: **23.04.2025**
(21) Numéro de dépôt: 23215797.4
(22) Date de dépôt: 12.12.2023
(51) Int. Cl.: H10F 39/12

(54) **DISPOSITIF D'ACQUISITION D'IMAGES**
BILDERFASSUNGSVORRICHTUNG
IMAGE ACQUISITION DEVICE

(30) Priorité: 14.12.2022 FR 2213292
(43) Date de publication de la demande: 19.06.2024
(73) Titulaire: STMicroelectronics Crolles 2 SAS, 38920 Crolles (FR)
(72) Inventeur: GAY, Laurent, 38660 LUMBIN (FR); GREGOIRE, Magali, 38920 CROLLES (FR); SAIDI, Bilel, 38000 GRENOBLE (FR); JOBLOT, Sylvain, 38300 DOMARIN (FR); VIANNE, Benjamin, 38570 LE CHEYLAS (FR)
(74) Mandataire: Cabinet Beaumont

(56) Documents cités:
- US-A1- 2016 315 113
- US-A1- 2020 083 274

## Description

### Domaine technique

La présente description concerne de façon générale le domaine des dispositifs électroniques et vise, plus particulièrement, le domaine des dispositifs d'acquisition d'images, et en particulier des dispositifs comportant un empilement d'un capteur d'images infrarouges et d'un capteur d'images visibles.

### Technique antérieure

On a déjà proposé un dispositif d'acquisition d'images comprenant un empilement de plusieurs capteurs et notamment des capteurs de types différents, par exemple un capteur d'images infrarouges et un capteur d'images visibles, par exemple en vue d'acquérir simultanément ou successivement une image visible et carte de profondeur d'une même scène.

Le document US 2016/315113 A1 décrit un capteur d'images selon l'art antérieur.

Il existe un besoin d'amélioration des dispositifs d'acquisition d'images comportant des capteurs empilés, et de leurs procédés de fabrication. Résumé de l'invention

Pour cela, un mode de réalisation prévoit un capteur d'images comprenant :
- une pluralité de pixels de photo-détection formés dans et sur un substrat semiconducteur ; et
- un réseau d'interconnexion revêtant une face du substrat semiconducteur, le réseau d'interconnexion comprenant un niveau de vias conducteurs en contact, par leur face inférieure, avec les pixels de photo-détection,
dans lequel lesdits vias conducteurs sont en silicium polycristallin dopé et présentent un dopage plus important du côté de leur face inférieure que du côté de leur face supérieure.

Selon un mode de réalisation, lesdits vias conducteurs présentent un gradient de dopage décroissant en partant de la face supérieure du substrat.

Selon un mode de réalisation, les vias conducteurs sont dopés d'atomes de phosphore ou d'arsenic.

Un autre mode de réalisation prévoit un procédé de fabrication d'un capteur d'images comprenant :
- la formation d'une pluralité de pixels de photo-détection dans et sur un substrat semiconducteur ; et
- la formation d'un niveau de vias conducteurs d'un réseau d'interconnexion, les vias étant en contact par leur face inférieure avec les pixels de photo-détection, les vias conducteurs étant en silicium polycristallin dopé et présentant un dopage plus important du côté de leur face inférieure que du côté de leur face supérieure.

Selon un mode de réalisation, lesdits vias présentent un gradient de dopage décroissant en partant de la face supérieure du substrat.

Selon un mode de réalisation, la formation des vias conducteurs comprend une étape de formation d'ouvertures dans une couche isolante, en contact avec les pixels de photo-détection.

Selon un mode de réalisation, la formation des vias conducteurs comprend, après l'étape de formation des ouvertures, les étapes successives suivantes :
- formation d'un film en silicium amorphe sur et dans les ouvertures ;
- dopage ex-situ dudit film par l'implantation de dopants ; et
- remplissage des ouvertures par une couche en silicium amorphe.

Selon un mode de réalisation, à l'issue de l'étape de dopage du film, ledit film a un dopage de l'ordre de 1.10²¹ at/cm³.

Selon un mode de réalisation, le silicium amorphe du film est en outre dopé in-situ pendant son dépôt.

Selon un mode de réalisation, le silicium de ladite couche est dopé in-situ pendant son dépôt.

Selon un mode de réalisation, la formation des vias conducteurs comprend, après l'étape de formation des ouvertures les étapes successives suivantes :
- remplissage des ouvertures par une couche en silicium amorphe ; et
- dopage ex-situ de ladite couche, au voisinage du substrat semiconducteur, par l'implantation de dopants.

Selon un mode de réalisation, le silicium de ladite couche est en outre dopé in-situ pendant son dépôt.

Selon un mode de réalisation, à l'issue de l'étape de dopage de la couche, ladite couche a un dopage, au voisinage du substrat de l'ordre de 1.10²¹ at/cm³.

Selon un mode de réalisation, le procédé comprend, après la formation des ouvertures dans la couche isolante en contact avec les pixels de photo-détection, une étape d'amorphisation de la surface du substrat et de la surface de grilles conductrices en silicium polycristallin au fond des ouvertures d'ouvertures.

Un autre mode de réalisation prévoit un dispositif d'acquisition d'images comportant un premier capteur d'images et un deuxième capteur d'images tels que définis ci-dessus, le premier capteur d'mages et le deuxième capteur d'images étant empilés.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une vue en coupe, partielle et schématique, d'un dispositif d'acquisition d'images selon un mode de réalisation ;
la figure 2 est une vue en coupe, plus détaillée, d'une partie du dispositif d'acquisition d'images de la figure 1 ;
la figure 3A, la figure 3B, la figure 3C, la figure 3D, la figure 3E, la figure 3F, la figure 3G, la figure 3H, la figure 3I, la figure 3J, la figure 3K, la figure 3L, figure 3M, la figure 3N, la figure 3O et la figure 3P sont des vues en coupe illustrant des étapes d'un procédé de fabrication de la partie du dispositif d'acquisition d'image illustrée en figure 2 selon un premier mode de mise en oeuvre ;
la figure 4A et la figure 4B sont des vues en coupe illustrant des étapes d'un procédé de fabrication de la partie du dispositif d'acquisition d'image illustrée en figure 2 selon un deuxième mode de mise en oeuvre ; et
la figure 5 est une vue en coupe illustrant une étape d'un procédé de fabrication de la partie du dispositif d'acquisition d'image illustrée en figure 2 selon un troisième mode de mise en oeuvre.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, seules des étapes permettant la réalisation d'un réseau d'interconnexion d'un capteur ont été détaillées ci-après. La réalisation des autres éléments du dispositif d'acquisition d'images, par exemple la réalisation des photorécepteurs et des circuits de lecture associés, n'a pas été détaillée, les modes de réalisation décrits étant compatibles avec les réalisations usuelles de ces éléments ou la réalisation de ces éléments étant à la portée de la personne du métier à partir des indications de la présente description.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

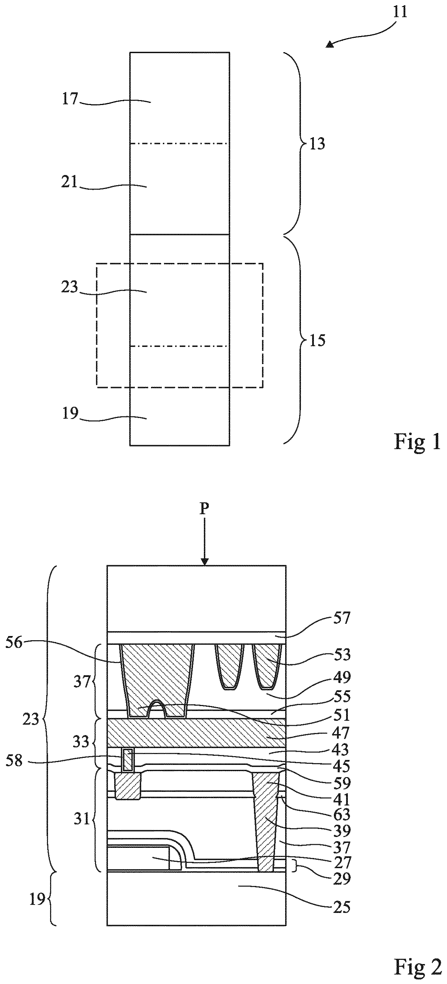

La figure 1 est une vue en coupe, partielle et schématique, d'un dispositif d'acquisition d'images 11 selon un mode de réalisation.

Le dispositif d'acquisition d'images 11 correspond, par exemple, à l'assemblage d'une première structure 13 correspondant à un premier capteur d'images, et d'une deuxième structure 15 correspondant à un deuxième capteur d'images. Le premier capteur d'images est, par exemple, un capteur d'images infrarouges et le deuxième capteur d'images est, par exemple, un capteur d'images visibles, par exemple un capteur d'images couleurs. Dans cet exemple, les deux capteurs infrarouge 13 et visible 15 sont empilés l'un au dessus de l'autre.

A titre d'exemple, chacun des capteurs 13 et 15 comprend un ensemble de pixels formés dans et sur un substrat semiconducteur. Chaque pixel comprend par exemple un photorécepteur, par exemple une photodiode, et un circuit de lecture du photorécepteur. Ainsi, le capteur 13 comprend un ensemble de pixels 17 et le capteur 15 comprend un ensemble de pixels 19. En outre, chacun des capteurs 13 et 15 comprend un réseau d'interconnexion des pixels du capteur. Le capteur 13 comporte ainsi un réseau d'interconnexion 21 et le capteur 15 comporte un réseau d'interconnexion 23. Dans l'exemple représenté, le capteur infrarouge 13 est disposé sur le capteur visible 15. La face inférieure du réseau d'interconnexion 21 du capteur 13 est en contact avec la face supérieure du réseau d'interconnexion 23 du capteur 15. L'ensemble de pixels 17 du capteur infrarouge 13 est disposé du côté de la face supérieure du réseau d'interconnexion 21. L'ensemble de pixels 19 du capteur visible 15 est disposé du côté de la face inférieure du réseau d'interconnexion 23.

Le dispositif 11 est, dans l'exemple illustré en figure 1, destiné à être éclairé par sa face inférieure. Les rayonnements visibles sont absorbés par les photodétecteurs des pixels du capteur 15, ce qui permet l'acquisition d'une image dans la gamme des longueurs d'onde du spectre visible. Le capteur 15 est en revanche sensiblement transparent aux rayonnements infrarouges. Ces rayonnements sont absorbés par les photodétecteurs du capteur 13 ce qui permet l'acquisition d'une image dans la gamme de longueurs d'ondes du spectre infrarouge et proche infrarouge.

Dans chacun des capteurs 13 et 15, les pixels du capteur sont par exemple disposés en matrice selon des lignes et des colonnes.

La figure 2 est une vue en coupe, plus détaillée, d'une partie du dispositif d'acquisition d'images 11 de la figure 1. Plus précisément, la figure 2 représente de façon plus détaillée la partie du dispositif 11 de la figure 1 entourée par des pointillés en figure 1, c'est-à-dire une partie du réseau d'interconnexion 23 et une partie de l'ensemble de pixels 19 du capteur 15.

En figure 2, une partie d'un pixel P du capteur 15 est représentée. A titre d'exemple, chaque pixels P comprend un photodétecteur, non représenté, formés dans et sur un substrat 25. Le substrat 25 est par exemple en un matériau semiconducteur, par exemple en silicium. Chaque photodétecteurs est par exemple connecté à un circuit de lecture comprenant des transistors comportant des grilles 27, formées sur le substrat 25. Les grilles 27 sont, par exemple, en silicium polycristallin, par exemple dopé d'un premier type de conductivité, par exemple du type N, par exemple dopé d'atomes de phosphore.

Les faces supérieures du substrat 25 et les grilles 27 sont par exemple recouvertes par une couche isolante 29, par exemple traversée par des vias 41 reliant le réseau d'interconnexion 33 à l'ensemble des photodétecteurs et de leurs circuits de lecture. A titre d'exemple, la couche 29 est constitué d'un nitrure et/ou d'un oxyde, par exemple d'un nitrure de silicium (SiₓN_{y}), d'un carbonitrure de silicium (SiCₓN_{y}) et/ou d'un dioxyde de silicium (SiO₂). A titre d'exemple, la couche 29 comprend une première sous-couche sur et en contact avec la face supérieure du substrat 25 et de la face supérieure des grilles 27 et une deuxième sous-couche sur et en contact avec la face supérieure de la première sous-couche. La première sous-couche est par exemple en dioxyde de silicium. La deuxième sous-couche est par exemple en nitrure de silicium.

Le réseau d'interconnexion 23 est constitué d'un empilement ou réseau de niveaux électriquement conducteurs et de niveaux électriquement isolants dans lesquels sont formés des éléments d'interconnexion. En figure 2, trois niveaux sont représentés dans le réseau d'interconnexion 23, un premier niveau 31 dit niveau inférieur, revêtant la face supérieure du substrat 25, par exemple sur et en contact avec la face supérieure de la couche 29, un deuxième niveau 33 revêtant le premier niveau, par exemple sur et en contact avec la face supérieure du premier niveau, et un troisième niveau revêtant le deuxième niveau, par exemple sur et en contact avec la face supérieure du deuxième niveau. En pratique, le réseau 23 peut comprendre un nombre de niveaux différent de trois, par exemple supérieur à trois.

A titre d'exemple, chaque niveau comprend une couche en un matériau isolant dans laquelle sont formés des pistes et des vias conducteurs.

Le niveau inférieur 31 comprend ainsi, par exemple, une couche électriquement isolante 37 dans laquelle sont formés des vias électriquement conducteurs 39 et des pistes électriquement conductrices 41. Similairement, le deuxième niveau 33 comprend, par exemple, une couche électriquement isolante 43 dans laquelle sont formés des vias électriquement conducteurs 45 et des pistes électriquement conductrices 47 et le troisième niveau 35 comprend, par exemple, une couche électriquement isolante 49 dans laquelle sont formés des vias électriquement conducteurs 51 et des pistes électriquement conductrices 53.

A titre d'exemple, les vias 39 sont en contact, par leur face inférieure, avec le substrat 25 ou avec les grilles 27 des transistors des circuits de lecture des pixels, et, par leur face supérieure, avec la face inférieure des pistes 41. Les vias 45 sont par exemple en contact, par leur face inférieure, avec la face supérieure des pistes 41, et, par leur face supérieure, avec la face inférieure des pistes 47. Les vias 51 sont par exemple en contact, par leur face inférieure, avec la face supérieure des pistes 47, et, par leur face supérieure, avec la face inférieure des pistes 53.

Les couches 37, 43 et 49 sont par exemple en dioxyde de silicium (SiO₂) et/ou en nitrure de silicium (SiₓN_{y}) et/ou en carbonitrure de silicium (SiCₓN_{y}). A titre d'exemple, les couches 37, 43 et 49 correspondent chacune à un empilement des matériaux susmentionnés.

Les vias 45 et 51 et les pistes 47 et 53 sont par exemple en métal, par exemple en métal de transition, par exemple en tungstène, en cuivre, en cobalt ou en ruthénium. A titre d'exemple, les vias 45 sont en tungstène, et les vias 51 et les pistes 53 et 47 sont en cuivre.

A titre d'exemple, les niveaux du réseau d'interconnexion 23 sont séparés par des couches d'encapsulation.

Dans l'exemple représenté, une couche d'encapsulation 55 recouvre ainsi le deuxième niveau et une couche d'encapsulation 57 recouvre le troisième niveau du réseau d'interconnexion 23. Les couches d'encapsulation 55 et 57 sont, par exemple en un matériau électriquement isolant permettant de faire barrière à la diffusion du cuivre ou de certains ions dans le silicium des couches 37, 43 et 49. A titre d'exemple, les couches d'encapsulation 55 et 57 sont en un matériau différent du cuivre, par exemple en nitrure de silicium ou en carbonitrure de silicium (SiCN).

Similairement, les vias 45 et 51 et pistes 53 et 47 sont par exemple entourés d'une couche permettant de faire barrière à la diffusion du matériau des vias, par exemple du cuivre ou du tungstène, dans le silicium des couches 43 et 49. Dans l'exemple représenté, les vias 51 et les pistes 53 et 47 sont par exemple entourés, par exemple encapsulés, d'une couche barrière 56 et le via 45 est par exemple entouré d'une couche barrière 58 d'une couche 58. La couche barrière 56 est par exemple en nitrure de tantale (TaN) et la couche barrière 58 est par exemple en titane et/ou en nitrure de titane (TiN).

A titre d'exemple, les pistes conductrices 41 du niveau 31 sont disposées sur et en contact avec une couche 63 et sont recouvertes et en contact avec une couche 59. Les couches 63 et 59 sont par exemple toutes deux en un matériau diélectrique, par exemple en nitrure, par exemple en nitrure de silicium.

La transparence du capteur 15, aux rayonnements captés par le capteur 13, est apportée par la transparence de l'ensemble des éléments décrit ci-avant et plus particulièrement de l'ensemble des photodétecteurs 19 et du réseau d'interconnexion 23.

A titre d'exemple, l'ensemble de pixels 19 du capteur 15 est transparent aux rayonnements infrarouges. Le réseau d'interconnexion 23 peut en revanche comporter des éléments de connexion électrique (pistes et/ou vias de connexion électrique), par exemple métalliques, non transparents aux rayonnements infrarouges.

Dans cet exemple, bien que cela ne soit pas représenté en figure 2, on prévoit de déporter en périphérie des pixels P, les pistes et les vias des niveaux supérieurs du réseau d'interconnexion 23. Ceci permet de laisser un passage transparent aux rayonnements infrarouges en vis à vis d'une partie centrale des pixels P.

Les vias 39 du niveau inférieur 31 du réseau d'interconnexion 23 permettent la reprise de contact sur la face supérieure des grilles 27 ainsi qu'à différents endroits à la surface du substrat 25, par exemple sur des nœuds de lecture des pixels P. Leur déportation en périphérie des pixels P n'est donc pas possible.

Selon un aspect d'un mode de réalisation, on prévoit de former les vias 39 et les pistes 41 du premier niveau du réseau d'interconnexion 23 en silicium polycristallin dopé, qui présente l'avantage d'être transparent aux rayonnements infrarouges. Afin de favoriser le contact ohmique avec les composants sous-jacents tout en maximisant la transparence, on prévoit en outre de doper les vias 39 avec un gradient de dopage décroissant en partant de leur face inférieure.

Ceci permet d'améliorer la transparence du réseau d'interconnexion 23 aux rayonnements infrarouges en vis à vis des pixels P, et ainsi d'augmenter le flux reçu par le capteur infrarouge 13.

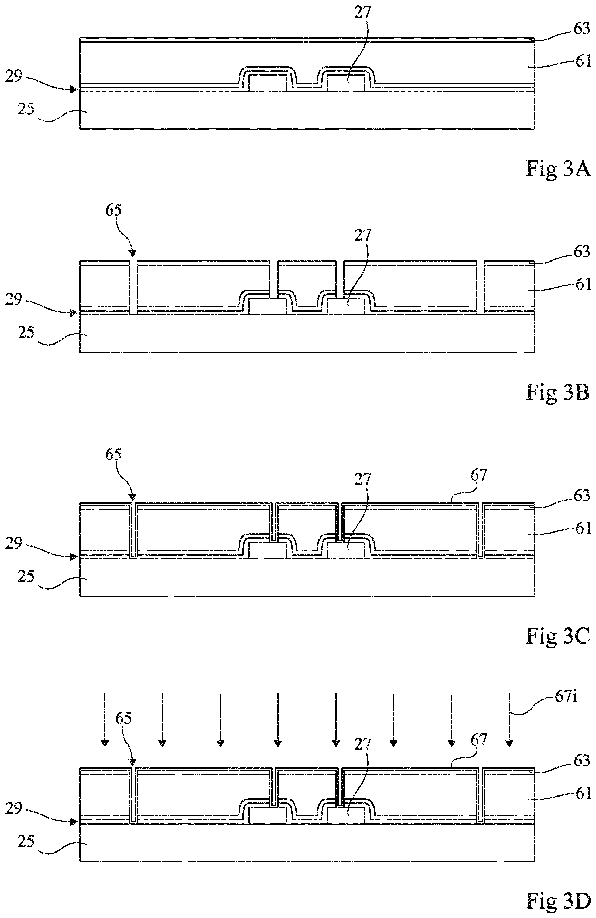

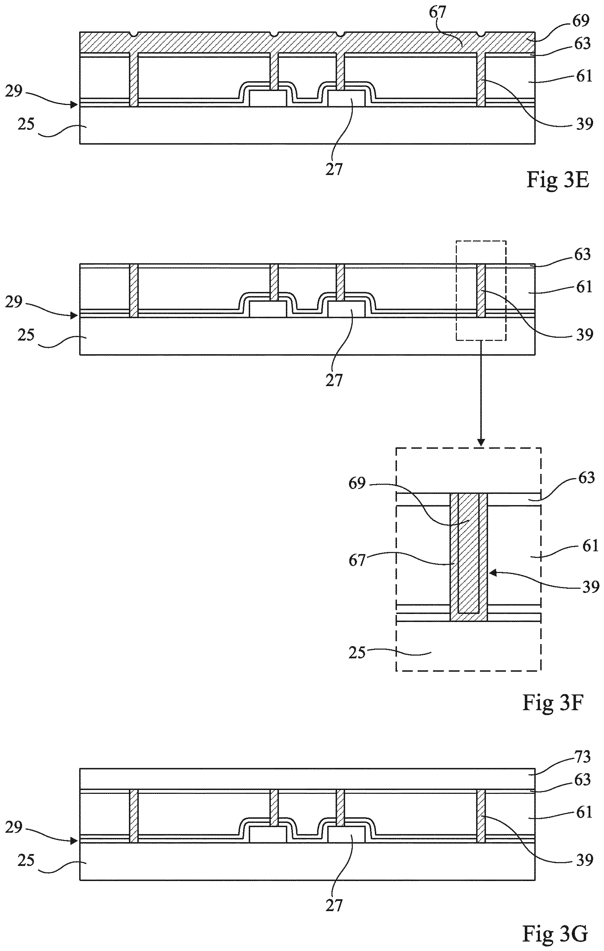

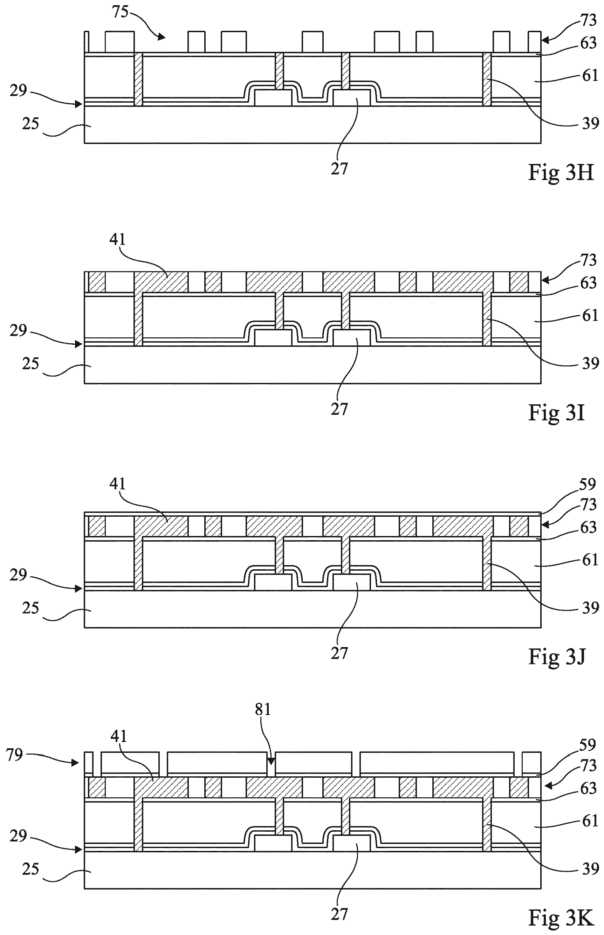

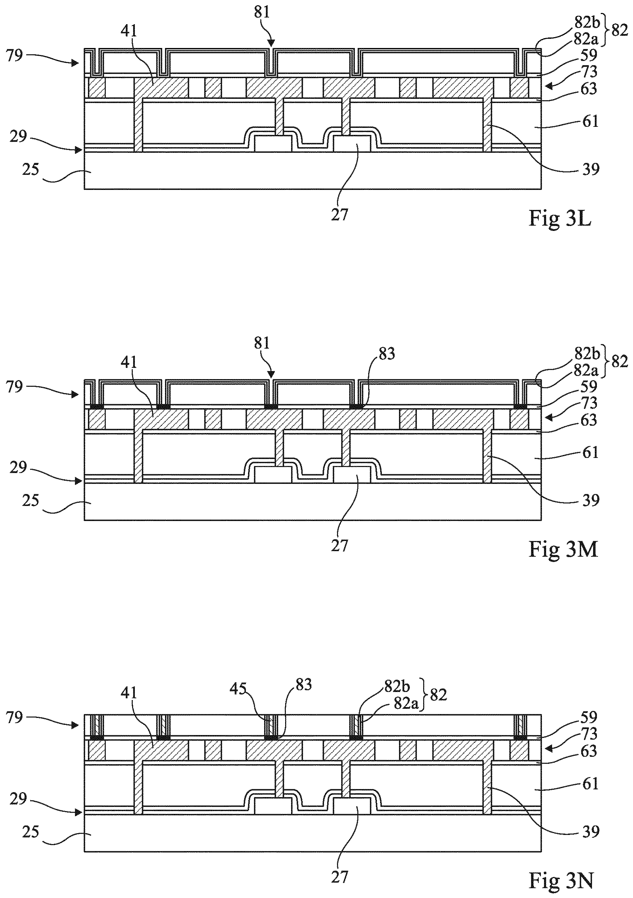

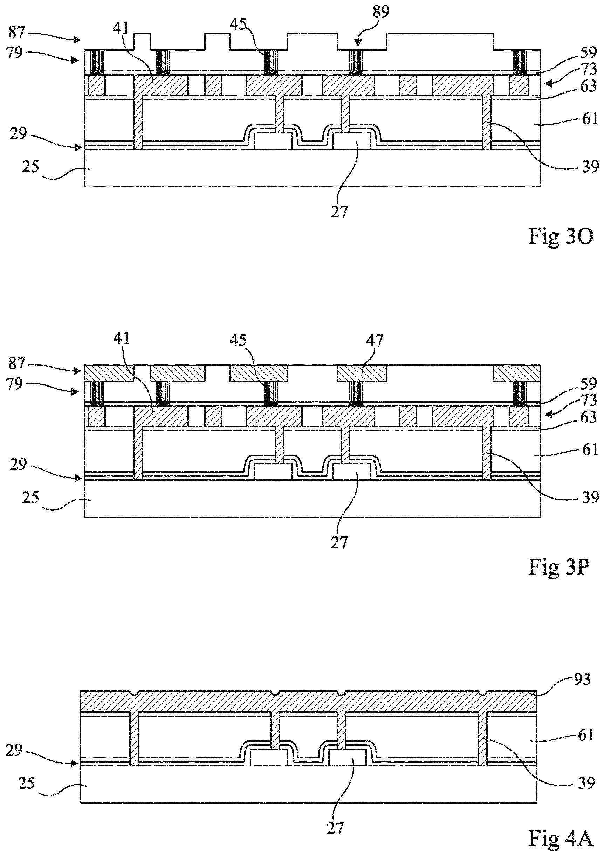

La figure 3A, la figure 3B, la figure 3C, la figure 3D, la figure 3E, la figure 3F, la figure 3G, la figure 3H, la figure 3I, la figure 3J, la figure 3K, la figure 3L, la figure 3M, la figure 3N, la figure 3O et la figure 3P sont des vues en coupe illustrant des étapes d'un procédé de fabrication de la partie du dispositif d'acquisition d'image illustrée en figure 2 selon un premier mode de mise en oeuvre.

La figure 3A illustre une structure de départ du procédé. Plus particulièrement, la figure 3A illustre de façon très schématique une partie seulement des éléments d'un pixel P.

La structure illustrée en figure 3A comprend le substrat 25 dans et sur lequel la pluralité de photodétecteurs et de transistors de lecture sont formés. A titre d'exemple, la structure illustrée en figure 3A comprend les grilles 27 de transistors de lecture formées sur le substrat 25 et, par exemple séparé du substrat 25 par une couche d'isolant de grille (non détaillée sur la figure).

Dans la structure de départ de la figure 3A, le substrat 25 et les grilles 27 sont par exemple recouvertes par la couche 29. A titre d'exemple, la couche 29 est formée de façon conforme, c'est-à-dire qu'elle est déposée avec une épaisseur constante sur toute la surface de la structure.

A titre d'exemple, la couche 29 est recouverte par une couche isolante 61. A titre d'exemple, la couche 61 est constituée d'un oxyde, par exemple de dioxyde de silicium (SiO₂). A titre d'exemple, la couche 61 recouvre la couche 29 avec une épaisseur comprise entre 190 nm et 500 nm, par exemple entre 300 nm et 450 nm, par exemple de l'ordre de 380 nm.

La couche 61 est, par exemple recouverte par une couche diélectrique 63. La couche 63 est par exemple constituée d'un nitrure, par exemple de nitrure de silicium (SiₓN_{y}) ou de carbonitrure de silicium (SiCₓN_{y}). A titre d'exemple, la couche 63 a une épaisseur comprise entre 10 nm et 100 nm, par exemple comprise entre 30 nm et 70 nm.

La figure 3B illustre une structure obtenue à l'issue d'une étape de formation d'ouvertures 65 dans la structure illustrée en figure 3A.

Plus particulièrement, on vient lors de cette étape former les ouvertures 65 à partir de la face supérieure de la structure illustrée en figure 3A, de sorte qu'elles débouchent sur la face supérieure du substrat 25 ou la face supérieure des grilles 27. Les ouvertures 65 traversent ainsi la couche 63, la couche 61 et la couche 29.

Lors de cette étape, on vient par exemple former plusieurs ouvertures 65. Une ouverture 65 est par exemple formée en vis-à-vis de chaque grille 27 et une ouverture 65 est par exemple formée en vis-à-vis de chaque nœud de lecture (non représentés) du substrat 25.

Les ouvertures 65 sont, par exemple, formées par gravure à travers une couche de masquage non représentée. A titre d'exemple, les ouvertures 65 ont une largeur comprise entre 50 nm et 150 nm, par exemple comprise entre 90 nm et 100 nm.

La figure 3C illustre une structure obtenue à l'issue d'une étape de dépôt d'un film 67 en silicium sur la structure illustrée en figure 3B. Plus particulièrement, le film 67 est déposé sur la face supérieure de la couche 63 et dans les ouvertures 65, plus particulièrement dans le fond et sur les flancs des ouvertures 65.

Lors de son dépôt, le film 67 est, par exemple, en silicium amorphe. A titre d'exemple, le film 67 est, par exemple, déposé de façon conforme c'est-à-dire qu'il est déposé sur toute la face supérieure de la structure illustrée en figure 3B avec une épaisseur sensiblement constante. Le film 67 a, par exemple une épaisseur comprise entre 19 nm et 40 nm, par exemple comprise entre 30 nm et 35 nm. A titre d'exemple, le film 67 est formé par dépôt chimique en phase vapeur à basse pression ou LPCVD (de l'anglais " Low Pressure Chemical Vapor Deposition").

A titre d'exemple, le matériau constituant le film 67 est dopé pendant son dépôt sur la face supérieure de la structure illustrée en figure 3B, on parle de dopage in-situ. Le matériau constituant le film 67 est, par exemple, dopé d'un premier type de conductivité, par exemple du type N, par exemple dopé d'atomes d'arsenic ou de phosphore. A titre d'exemple, à l'issue de cette étape, le film 67 a un dopage de l'ordre de 3.10¹⁹ at/cm³.

A titre d'exemple, le dépôt du film 67 est précédé d'une étape de traitement de la surface de la structure illustrée en figure 3C.

La figure 3D illustre une structure obtenue à l'issue d'une étape de dopage du film 67 de la structure illustrée en figure 3C. Lors de cette étape, on vient par exemple doper la structure illustrée en figure 3C par implantation d'éléments dopants par sa face supérieure, on parle ici de dopage ex-situ.

A titre d'exemple, cette étape est réalisée sans masque ou couche de masquage. Toutefois, la couche 63 peut agir comme couche de masquage en protégeant la couche 61 de l'implantation de dopants 67i. Ainsi, lors de cette étape, seul le film 67 est dopé et plus particulièrement le fond des ouvertures 65 est, entre autres, dopé. Cette étape de dopage consiste en l'implantation dans le film 67 d'atomes du premier type de conductivité, par exemple du type N, par exemple d'atomes d'arsenic ou de phosphore. Le dopage est, par exemple réalisé avec une dose comprise entre 2.10¹⁴ at/cm² et 1.10¹⁶ at/cm², par exemple comprise entre 5.10¹⁴ at/cm² et 1.10¹⁶ at/cm².

A titre d'exemple, à l'issue de cette étape, le film 67 a un dopage compris entre 4.10¹⁹ at/cm³ et 4.10²² at/cm³, par exemple de l'ordre de 1.10²¹ at/cm³.

La figure 3E illustre une structure obtenue à l'issue d'une étape de remplissage des ouvertures 65 de la structure illustrée en figure 3D.

Lors de cette étape, on vient remplir les ouvertures 65 et recouvrir la face supérieure de la structure illustrée en figure 3D par du silicium amorphe de façon à former une couche 69 sur et en contact avec la couche 67 dopée. A titre d'exemple, le silicium amorphe utilisé lors de cette étape est dopé in-situ pendant son dépôt, par exemple du premier type de conductivité, par exemple du type N, par exemple avec des atomes d'arsenic ou de phosphore. Le silicium amorphe utilisé pour former la couche 69 est par exemple dopé de l'ordre de 1.10²⁰ at/cm³.

De façon optionnelle, à l'issue de cette étape, on peut prévoir une étape supplémentaire de dopage et plus particulièrement une étape de dopage localisé du deuxième type de conductivité, par exemple du type P, par exemple dopé d'atomes de bore ou de difluorure de bore (BF₂). A titre d'exemple, cette étape a pour but de doper localement les parties de la couche 69 situées dans une partie des ouvertures 65 et plus précisément les parties de la couche 69 situées dans les ouvertures 65 qui sont en contact avec une zone du substrat 25 préférentiellement dopé P. Le dopage localisé est par exemple réalisé à travers une couche de masquage, par exemple en résine.

La figure 3F illustre une structure obtenue à l'issue d'une étape de polissage de la face supérieure de la structure illustrée en figure 3E. Sur cette figure, on a en outre représenté une agrandissement d'une portion de la structure comportant un via 39.

Lors de cette étape, on vient retirer la couche 69 et le film 67 de façon à dévoiler la face supérieure de la couche 63. Les parties de la couche 69 et du film 67 subsistant dans les ouvertures 65 forment ainsi les vias 39. A l'issue de cette étape, la face supérieure des vias 39 affleurent la face supérieure de la couche 63. L'étape de polissage est, par exemple réalisée par un procédé mécanique, par exemple un procédé mécano-chimique ou CMP (de l'anglais "Chemical Mechanical Polishing"). A titre d'exemple, cette étape permet d'aplanir la face supérieure de la structure jusqu'à la couche 63 permettent le contrôle de fin d'aplanissement.

L'étape de polissage est, par exemple, suivie d'une étape de recuit permettant l'activation du dopage des vias 39. A titre d'exemple, l'étape de recuit est réalisée sous une température supérieure à 800 °C, par exemple supérieure à 900 °C, par exemple comprise entre 900 °C et 1050 °C.

A l'issue de cette étape, le matériau des vias 39 passe d'un état amorphe à un état polycristallin. Les vias 39 sont, à l'issue de cette étape en un silicium polycristallin dopé. Les vias 39 étant formés du film 67 et de la couche 69, leurs dopages sont plus importants au voisinage du substrat 25, les vias 39 présentent ainsi un gradient de dopage décroissant en partant de la face supérieure du substrat 25.

La figure 3G illustre une structure obtenue à l'issue d'une étape de dépôt d'une couche 73 sur la face supérieure de la structure illustrée en figure 3F.

A titre d'exemple, lors de cette étape, on vient plus particulièrement déposer la couche 73 sur et en contact avec la face supérieure de la couche 63 et la face supérieure des vias 39. La couche 73 est par exemple en un matériau diélectrique, par exemple en oxyde de silicium, par exemple en dioxyde de silicium (SiO₂). A titre d'exemple, la couche 73 est déposée par dépôt chimique en phase vapeur assisté par plasma ou PECVD (de l'anglais "Plasma Enhanced Chemical Vapour Deposition"). A titre d'exemple, la couche 73 a une épaisseur comprise entre 100 nm et 500 nm, par exemple de l'ordre de 155 nm.

La figure 3H illustre une structure obtenue à l'issue d'une étape de formation d'ouvertures 75 dans la couche 73 de la structure illustrée en figure 3G.

Cette étape est similaire à l'étape de formation des ouvertures 65 dans les couches 61, 63 et 29 décrite en relation avec la figure 3B à la différence près que les ouvertures 75 sont formées à partir de la face supérieure de la couche 73 et qu'elles débouchent sur la face supérieure de la couche 63 et sur la face supérieure des vias 39. A titre d'exemple, les ouvertures 75 sont plus larges que les ouvertures 65, les ouvertures 65 accueillant les vias 39 et les ouvertures 41 accueillant le premier niveau de piste 41 du réseau d'interconnexion. A titre d'exemple, chaque via 39 est surmonté d'une ouverture 75.

La figure 3I illustre une structure obtenue à l'issue d'une étape de remplissage des ouvertures 75 de la structure illustrée en figure 3H.

Lors de cette étape, on vient dans un premier temps remplir les ouvertures 75 et recouvrir la face supérieure de la structure illustrée en figure 3H par du silicium amorphe, par exemple dopé in-situ.

Dans un deuxième temps, on vient retirer l'excès de silicium amorphe déposé sur la face supérieure de la structure de façon à dévoiler la face supérieure de la couche 73. A titre d'exemple, cette étape est réalisée par polissage. L'étape de polissage est, par exemple réalisée par un procédé mécanique, par exemple un procédé mécano-chimique ou CMP (de l'anglais "Chemical Mechanical Polishing"). La partie de silicium amorphe subsistant dans les ouvertures 75 forment ainsi les pistes 41. A l'issue de cette étape, la face supérieure des pistes 41 affleurent la face supérieure de la couche 73.

L'étape de polissage est, par exemple, suivie d'une étape de recuit. A titre d'exemple, l'étape de recuit est réalisée sous une température supérieure à 800 °C, par exemple supérieure à 900 °C, par exemple comprise entre 900 °C et 1050 °C.

A l'issue de cette étape, le matériau des pistes 41 passe d'un état amorphe à un état polycristallin.

La figure 3J illustre une structure obtenue à l'issue d'une étape de dépôt d'une couche 59 sur la face supérieure de la structure illustrée en figure 3I.

Lors de cette étape, on vient plus particulièrement recouvrir la face supérieure de la couche 73 et la face supérieure des pistes 41 par une couche 59.

La couche 59 est, par exemple formée pleine plaque. A titre d'exemple, la couche 59 est formée de façon conforme. A titre d'exemple, la couche 41 a une épaisseur comprise entre 10 nm et 100 nm, par exemple comprise entre 30 nm et 70 nm. La couche 41 est, par exemple déposée par PECVD.

La couche 59 est, par exemple constituée d'un matériau diélectrique, par exemple d'un nitrure, par exemple de nitrure de silicium (SiₓN_{y}) ou de carbonitrure de silicium (SiCₓN_{y}).

La formation de la couche 59 complète la formation du niveau inférieur 31 du réseau d'interconnexion 23. Les étapes 3K à 3O illustrent la formation d'un niveau supplémentaire du réseau d'interconnexion 23, par exemple le deuxième niveau 33, ces étapes sont donc, par exemple réitérées jusqu'à obtenir le nombre de niveaux souhaité dans le réseau d'interconnexion 23.

La figure 3K illustre une structure obtenue à l'issue d'une étape de formation d'une couche 79 sur la face supérieure de la structure illustrée en figure 3J suivie d'une étape de formation d'ouvertures 81 dans les couches 79 et 59.

A titre d'exemple, l'étape de formation de la couche 79 est similaire à l'étape de formation de la couche 79 décrite en relation avec la figure 3K et l'étape de formation des ouvertures 81 est similaire à l'étape de formation des ouvertures 41 décrite en relation avec la figure 3H.

A titre d'exemple, les ouvertures 81 sont formées en vis-à-vis des pistes 41 et débouchent sur les pistes 41.

La figure 3L illustre une structure obtenue à l'issue d'une étape de nettoyage du fond des ouvertures 81 et de formation d'une couche 82 sur la face supérieure de la structure illustrée en figure 3K.

A titre d'exemple, lors de cette étape, on vient dans un premier temps nettoyer le fond des ouvertures 81, par exemple à l'aide d'un plasma d'argon.

Dans un second temps, on vient former une couche 82 pleine plaque, comportant par exemple une sous-couche 82a et une sous-couche 82b, sur la face supérieure de la structure illustrée en figure 3K et plus particulièrement sur la face supérieure de la couche 79 et sur les flancs et dans le fond des ouvertures 81.

A titre d'exemple, la sous-couche 82a est en titane. La sous-couche 82a a, par exemple une épaisseur inférieure à 50 nm, par exemple inférieure 30 nm, par exemple comprise entre 5 nm et 30 nm. La sous-couche 82a est par exemple formée par un procédé de dépôt physique en phase vapeur ou PVD (de l'anglais "Physical Vapor Deposition"). La sous-couche 82b est, par exemple formée sur et en contact avec la sous-couche 82a. A titre d'exemple, la sous-couche 82b est en nitrure de silicium. La sous-couche 82b est par exemple formée par dépôt de couches atomiques successives ou ALD (de l'anglais "Atomic Layer Deposition"). La sous-couche 82b permet, par exemple, de protéger la sous-couche 82a de l'oxydation.

La figure 3M illustre une structure obtenue à l'issue d'une étape de recuit de la structure illustrée en figure 3L de façon à former un siliciure intermétallique 83 issu de la couche 82.

Lors de cette étape, la structure subie un recuit permettant de faire réagir le titane de la sous-couche 82a avec le silicium des pistes 41 de façon à former, dans le fond des ouvertures 81, un film mince d'un composé intermétallique appelé siliciure. Le siliciure est par exemple à base de silicium et de titane, le siliciure est un disiliciure de titane (TiSi₂) ou un siliciure de titane (TiSi) en fonction du recuit appliqué.

La figure 3N illustre une structure obtenue à l'issue d'une étape de remplissage des ouvertures 81 de la structure illustrée en figure 3M, de façon à former les vias 45.

Lors de cette étape, on vient dans un premier temps remplir les ouvertures 81 et recouvrir la face supérieure de la structure illustrée en figure 3M avec un matériau métallique. A titre d'exemple, le matériau métallique est en cuivre, en tungstène ou en cobalt.

A titre d'exemple, le remplissage des ouvertures 81 est réalisé alors que les parties de la couche 82 qui n'ont pas réagit avec le silicium des contacts 41, lors de l'étape de formation du siliciure 83, sont conservées sur les flancs des ouvertures 81. La couche 82 a ainsi une fonction barrière à la diffusion du matériau des vias 45 dans la couche 79.

Dans un deuxième temps, on vient retirer l'excès de matériau métallique déposé sur la face supérieure de la structure de façon à dévoiler la face supérieure de la couche 79. A titre d'exemple, cette étape est réalisée par polissage. L'étape de polissage est, par exemple réalisée par un procédé mécanique, par exemple un procédé mécano-chimique ou CMP (de l'anglais "Chemical Mechanical Polishing"). Ce qui subsiste de matériau métallique dans les ouvertures 81 forme ainsi les pistes 45. A l'issue de cette étape, la face supérieure des pistes 45 affleurent la face supérieure de la couche 79.

La figure 3O illustre une structure obtenue à l'issue d'une étape de formation d'une couche 87 sur la face supérieure de la structure illustrée en figure 3N suivie d'une étape de formation d'ouvertures 89 dans la couche 87.

A titre d'exemple, l'étape de formation de la couche 87 est similaire à l'étape de formation de la couche 73 décrite en relation avec la figure 3G et l'étape de formation des ouvertures 89 est similaire à l'étape de formation des ouvertures 41 décrite en relation avec la figure 3H.

A titre d'exemple, chaque via 45 est surmonté d'une ouverture 89.

La figure 3P illustre une structure obtenue à l'issue d'une étape de remplissage des ouvertures 89 de la structure illustrée en figure 3O, de façon à former les pistes 47.

Lors de cette étape, on vient, dans un premier temps déposer une couche barrière, non représentée, pleine plaque sur la face supérieure de la structure illustrée en figure 3O, et plus précisément dans le fond et sur les flancs des ouvertures 89. Cette couche barrière permet, par exemple d'éviter la diffusion des atomes de cuivre dans la couche 87. A titre d'exemple, la couche barrière est en tantale et/ou en nitrure de tantale (TaN). A titre d'exemple, la couche barrière comprend une première sous-couche en nitrure de tantale. A titre d'exemple, la couche barrière comprend une deuxième sous-couche en tantale.

Dans un deuxième temps, on vient former les contacts 47, dans les ouvertures 89, sur et en contact avec la couche barrière. A titre d'exemple, les contacts 47 sont en un matériau métallique, par exemple en cuivre.

A titre d'exemple, les contacts 47 sont formés par dépôt d'une couche de cuivre, par exemple pleine plaque. Le dépôt de la couche de cuivre est, par exemple suivie d'une croissance électrolytique de cette couche.

A titre d'exemple, à l'issue de l'étape de croissance électrolytique, une étape de polissage, par exemple mécanochimique est réalisée de façon à découvrir la face supérieure de la couche 87. A l'issue de cette étape, la face supérieure des contacts 47 affleurent la face supérieure de la couche 87.

Bien que cela ne soit pas représentée, la formation du niveau 33 du réseau d'interconnexion 23 est, par exemple, complétée par la formation d'une couche en un diélectrique, par exemple en un nitrure, par exemple en nitrure de silicium (SiₓN_{y}) ou en carbonitrure de silicium (SiCₓN_{y}).

Un avantage du premier mode de réalisation est qu'il permet le dopage de la partie du film 67 située sur les flancs des ouvertures 65, créant ainsi une zone plus conductrice sur le flanc des vias 39 et abaissant la résistance de ceux-ci.

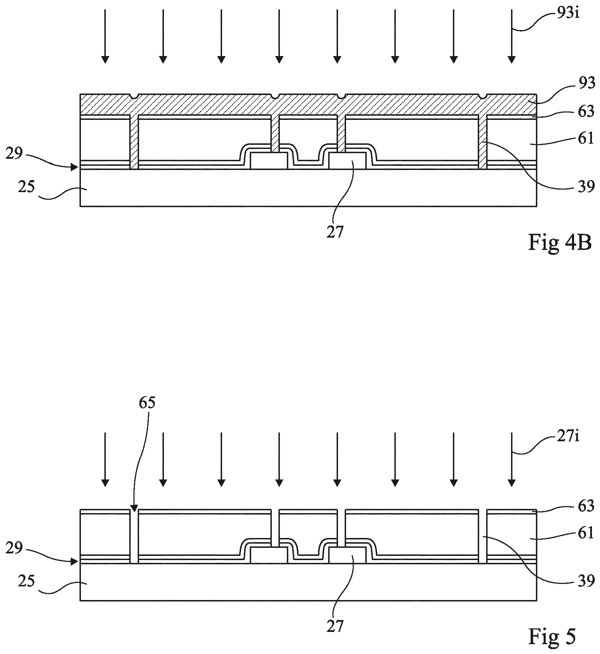

La figure 4A et la figure 4B sont des vues en coupe illustrant des étapes d'un procédé de fabrication de la partie du dispositif d'acquisition d'image illustrée en figure 2 selon un deuxième mode de mise en oeuvre.

Le deuxième mode de réalisation diffère du premier mode de réalisation en ce que, à l'issue de l'étape décrite en relation avec la figure 3B, les ouvertures 65 sont remplies d'une couche 93 en silicium sans formation préalable du film 67 (comme cela a été décrit en relation avec la figure 3C) et en ce que la couche 93 subit une implantation à la suite de son dépôt.

La figure 4A illustre une structure obtenue à l'issue d'une étape de dépôt de la couche 93 dans les ouvertures 65 et à la surface de la structure illustrée en figure 3B.

Lors de cette étape, on vient remplir les ouvertures 65 et recouvrir la face supérieure de la structure illustrée en figure 3B et par du silicium amorphe de façon à former la couche 93 sur et en contact avec la couche 63. A titre d'exemple, la couche est, lors de cette étape, dopée in-situ pendant son dépôt, par exemple du premier type de conductivité, par exemple du type N, par exemple avec des atomes d'arsenic ou de phosphore. Le silicium amorphe utilisé pour former la couche 93 est, par exemple, dopé de l'ordre de 1.10¹⁹ at/cm³.

La figure 4B illustre une structure obtenue à l'issue d'une étape de dopage de la couche 93 de la structure illustrée en figure 4A. Lors de cette étape, on vient par exemple doper la structure illustrée en figure 4A par sa face supérieure.

A titre d'exemple, cette étape est réalisée sans masque ou couche de masquage. Toutefois, la couche 63 peut agir comme couche de masquage en protégeant la couche 61 de l'implantation de dopants 93i.

Ainsi, lors de cette étape, seule la couche 93 est dopée et plus particulièrement les parties de la couche 93 situées dans les ouvertures 65 sont, entre autres, dopées. Cette étape de dopage consiste en l'implantation dans la couche susmentionnée d'atomes d'arsenic ou de phosphore. A titre d'exemple, le dopage de la couche 93 correspond à un dopage en profondeur, c'est-à-dire que les parties de la couche 93 situées au fond des ouvertures 65 seront plus dopées que les parties de la couche 93 situées à la surface des ouvertures 65. Le dopage est, par exemple réalisé avec une dose comprise entre 2.10¹⁴ at/cm ² et 1.10¹⁶ at/cm², par exemple comprise entre 5.10¹⁴ at/cm² et 1.10¹⁶ at/cm².

A l'issue de cette étape, la couche 93 a, par exemple, un dopage, au voisinage du substrat 25 et des grilles 27, compris entre 4.10¹⁹ at/cm³ et 4.10²² at/cm³, par exemple de l'ordre de 1.10²¹ at/cm³.

De façon optionnelle, à l'issue de cette étape, on peut prévoir une étape supplémentaire de dopage et plus particulièrement une étape de dopage localisé du deuxième type de conductivité, par exemple du type P similairement à ce qui a été décrit en relation avec la figure 3E.

A l'issue de cette étape, le deuxième mode de réalisation est identique au premier mode de réalisation, l'étape de dopage est alors suivie des étapes illustrées en figures 3F à 3O.

L'étape décrite en relation avec la figure 3F de polissage et de recuit de la structure, permet de former les vias 39 à partir de la couche 93. Lors de cette étape, le matériau des vias 39 passe d'un état amorphe à un état polycristallin. Les vias 39 sont, à l'issue de cette étape en un silicium polycristallin dopé avec un gradient de dopage décroissant en partant de la face supérieure du substrat 25.

La figure 5 est une vue en coupe illustrant une étape d'un procédé de fabrication de la partie du dispositif d'acquisition d'image illustrée en figure 2 selon un troisième mode de mise en oeuvre.

Le troisième mode de réalisation est similaire au premier mode de réalisation à la différence près qu'il comprend une étape de traitement de la face supérieure de la structure illustrée en figure 3B.

Lors de cette étape, on vient par exemple amorphiser la face supérieure de la structure illustrée en figure 3B et plus particulièrement, les parties de la surface des grilles 27 et du substrat 25 situées en vis-à-vis des ouvertures 65. Cette étape permet un réarrangement cristallographique des parties mentionnées ci-avant et ainsi un meilleur contact électrique avec le via 39 formé à posteriori dans les ouvertures 65.

A titre d'exemple cette étape consiste en l'implantation d'ions neutres 27i, par exemple d'argon, d'azote, de fluor, de silicium ou de germanium.

A titre d'exemple, à l'issue de cette étape, le troisième mode de réalisation est identique au premier mode de réalisation.

En variante, l'étape illustrée en figure 5 est suivie d'une étape de formation de contacts en silicium polycristallin ne présentant pas de gradient de dopage. Dans ce cas, le contact ohmique entre les vias 39 et le substrat 25 ou les grilles 27 reste amélioré du fait du réarrangement cristallographique résultant de l'étape d'amorphisation surfacique du silicium au fond des ouvertures 65.

Un avantage des modes de réalisation décrits est qu'ils permettent de former des vias 39 en silicium polycristallin dans un niveau inférieur du réseau d'interconnexion avec un gradient de dopage, améliorant ainsi le contact ohmique avec les grilles 27 ou le substrat 25.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

En particulier, les deuxième et troisième modes de réalisation peuvent être combinés.

De plus, les modes de réalisation décrits peuvent s'appliquer dans le cadre d'un dispositif comportant un unique capteur éclairé par sa face supérieure. Le réseau d'interconnexion est alors rendu transparent aux rayonnements captés par les détecteurs du même capteur.

Encore, les modes de réalisation ne se limitent pas aux exemples de valeurs numériques ni aux exemples de matériaux mentionnés dans la présente description.

Enfin, la mise en oeuvre pratique des modes de réalisation et variantes décrits est à la portée de la personne du métier à partir des indications fonctionnelles données ci-dessus.

## Revendications

1. Capteur d'images (15) comprenant :
- une pluralité de pixels de photo-détection (19) formés dans et sur un substrat semiconducteur (25) ; et
- un réseau d'interconnexion (23) revêtant une face du substrat semiconducteur, le réseau d'interconnexion comprenant un niveau (31) de vias conducteurs (39) en contact, par leur face inférieure, avec les pixels de photo-détection,
dans lequel lesdits vias conducteurs sont en silicium polycristallin dopé et **caractérisé en ce que** lesdits vias présentent un dopage plus important du côté de leur face inférieure que du côté de leur face supérieure.

2. Capteur selon la revendication 1, dans lequel lesdits vias conducteurs (39) présentent un gradient de dopage décroissant en partant de la face supérieure du substrat (25).

3. Capteur d'image selon la revendication 1 ou 2, dans lequel les vias conducteurs (39) sont dopés d'atomes de phosphore ou d'arsenic.

4. Procédé de fabrication d'un capteur d'images (15) comprenant :
- la formation d'une pluralité de pixels de photo-détection (19) dans et sur un substrat semiconducteur (25) ; et
- la formation d'un niveau (31) de vias conducteurs (39) d'un réseau d'interconnexion (23), les vias (39) étant en contact par leur face inférieure avec les pixels de photo-détection, les vias conducteurs (39) étant en silicium polycristallin dopé et présentant un dopage plus important du côté de leur face inférieure que du côté de leur face supérieure.

5. Procédé selon la revendication 4, dans lequel lesdits vias (39) présentent un gradient de dopage décroissant en partant de la face supérieure du substrat.

6. Procédé selon la revendication 4 ou 5, dans lequel la formation des vias conducteurs (39) comprend une étape de formation d'ouvertures (65) dans une couche isolante (61), en contact avec les pixels de photo-détection (19).

7. Procédé selon la revendication 6, dans lequel la formation des vias conducteurs (39) comprend, après l'étape de formation des ouvertures (65), les étapes successives suivantes :
- formation d'un film (67) en silicium amorphe sur et dans les ouvertures (65) ;
- dopage ex-situ dudit film (67) par l'implantation de dopants ; et
- remplissage des ouvertures (65) par une couche (69) en silicium amorphe.

8. Procédé selon la revendication 7, dans lequel à l'issue de l'étape de dopage du film (67), ledit film a un dopage de l'ordre de 1.10²¹ at/cm³.

9. Procédé selon la revendication 7 ou 8, dans lequel le silicium amorphe du film (67) est en outre dopé in-situ pendant son dépôt.

10. Procédé selon l'une quelconque des revendications 7 à 9, dans lequel le silicium de ladite couche (69) est dopé in-situ pendant son dépôt.

11. Procédé selon la revendication 6, dans lequel la formation des vias conducteurs (39) comprend, après l'étape de formation des ouvertures (65) les étapes successives suivantes :
- remplissage des ouvertures (65) par une couche (93) en silicium amorphe ; et
- dopage ex-situ de ladite couche (93), au voisinage du substrat semiconducteur (25), par l'implantation de dopants.

12. Procédé selon la revendication 11, dans lequel le silicium de ladite couche (93) est en outre dopé in-situ pendant son dépôt.

13. Procédé selon la revendication 11 ou 12, dans lequel à l'issue de l'étape de dopage de la couche (93), ladite couche a un dopage, au voisinage du substrat (25) de l'ordre de 1.10²¹ at/cm³.

14. Procédé selon l'une quelconque des revendications 6 à 13, comprenant, après la formation des ouvertures (65) dans la couche isolante (61) en contact avec les pixels de photo-détection, une étape d'amorphisation de la surface du substrat (25) et de la surface de grilles conductrices (27) en silicium polycristallin au fond des ouvertures d'ouvertures (65).

15. Dispositif d'acquisition d'images (11) comportant un premier capteur d'images (13) et un deuxième capteur d'images (15) selon l'une quelconque des revendications 1 à 3, le premier capteur d'mages et le deuxième capteur d'images étant empilés.

## Patentansprüche

1. Bildsensor (15), aufweisend:
- eine Vielzahl von Fotodetektionspixeln (19), die innerhalb und auf einem Halbleitersubstrat (25) ausgebildet sind; und
- ein Verbindungsnetzwerk (23), das eine Oberfläche des Halbleitersubstrats bedeckt, wobei das Verbindungsnetzwerk eine Ebene (31) leitender Durchkontaktierungen (39) aufweist, die mit ihrer unteren Oberfläche mit den Fotodetektionspixeln in Kontakt stehen,
wobei die leitenden Durchkontaktierungen aus dotiertem Polysilizium bestehen und **dadurch gekennzeichnet sind, dass** die Durchkontaktierungen auf ihrer unteren Oberflächenseite eine stärkere Dotierung aufweisen als auf ihrer oberen Oberflächenseite.

2. Sensor nach Anspruch 1, wobei die leitenden Durchkontaktierungen (39) einen abnehmenden Dotierungsgradienten aufweisen, der von der oberen Oberfläche des Substrats (25) ausgeht.

3. Bildsensor nach Anspruch 1 oder 2, wobei die leitenden Durchkontaktierungen (39) mit Phosphor- oder Arsenatomen dotiert sind.

4. Verfahren zur Herstellung eines Bildsensors (15), aufweisend:
- das Ausbilden einer Vielzahl von Fotodetektionspixeln (19) innerhalb und auf einem Halbleitersubstrat (25); und
- das Ausbilden einer Ebene (31) von leitenden Durchkontaktierungen (39) eines Verbindungsnetzwerks (23), wobei die Durchkontaktierungen (39) mit ihrer unteren Oberfläche mit den Fotodetektionspixeln in Kontakt stehen, wobei die leitenden Durchkontaktierungen (39) aus dotiertem Polysilizium bestehen und auf ihrer unteren Oberflächenseite eine stärkere Dotierung aufweisen als auf ihrer oberen Oberflächenseite.

5. Verfahren nach Anspruch 4, wobei die Durchkontaktierungen (39) einen abnehmenden Dotierungsgradienten aufweisen, der von der oberen Oberfläche des Substrats ausgeht.

6. Verfahren nach Anspruch 4 oder 5, wobei das Ausbilden der leitenden Durchkontaktierungen (39) einen Schritt des Ausbildens von Öffnungen (65) in einer Isolierschicht (61) in Kontakt mit den Fotodetektionspixeln (19) aufweist.

7. Verfahren nach Anspruch 6, wobei das Ausbilden der leitenden Durchkontaktierungen (39) nach dem Schritt des Ausbildens der Öffnungen (65) die folgenden aufeinanderfolgenden Schritte aufweist:
- Ausbilden eines amorphen Siliziumfilms (67) auf und im Inneren der Öffnungen (65);
- Ex-situ-Dotieren des Films (67) durch Implantation von Dotierstoffen; und
- Füllen der Öffnungen (65) mit einer amorphen Siliziumschicht (69).

8. Verfahren nach Anspruch 7, wobei der Film am Ende des Schritts der Dotierung des Films (67) eine Dotierung in der Größenordnung von 1,10²¹ at/cm³ aufweist.

9. Verfahren nach Anspruch 7 oder 8, wobei das amorphe Silizium des Films (67) ferner während seiner Abscheidung in-situ dotiert wird.

10. Verfahren nach einem der Ansprüche 7 bis 9, wobei das Silizium der Schicht (69) während seiner Abscheidung in-situ dotiert wird.

11. Verfahren nach Anspruch 6, wobei das Ausbilden der leitenden Durchkontaktierungen (39) nach dem Schritt des Ausbildens der Öffnungen (65) die folgenden aufeinanderfolgenden Schritte aufweist:
- Füllen der Öffnungen (65) mit einer amorphen Siliziumschicht (93); und
- Ex-situ-Dotieren der Schicht (93) in der Nähe des Halbleitersubstrats (25) durch Implantation von Dotierstoffen.

12. Verfahren nach Anspruch 11, wobei das Silizium der Schicht (93) während seiner Abscheidung ferner in-situ dotiert wird.

13. Verfahren nach Anspruch 11 oder 12, wobei die Schicht am Ende des Schritts des Dotierens der Schicht (93) in der Nähe des Substrats (25) eine Dotierung in der Größenordnung von 1,10²¹ at/cm³ aufweist.

14. Verfahren nach einem der Ansprüche 6 bis 13, dass nach dem Ausbilden der Öffnungen (65) in der Isolierschicht (61) in Kontakt mit den Fotodetektionspixeln einen Schritt der Amorphisierung der Oberfläche des Substrats (25) und der Oberfläche von leitenden Polysilizium-Gates (27) am Boden der Öffnungen (65) aufweist.

15. Bildaufnahmevorrichtung (11), die einen ersten Bildsensor (13) und einen zweiten Bildsensor (15) aufweist, gemäß einem der Ansprüche 1 bis 3, wobei der erste Bildsensor und der zweite Bildsensor gestapelt sind.

## Claims

1. Image sensor (15) comprising:
- a plurality of photodetection pixels (19) formed inside and on top of a semiconductor substrate (25); and
- an interconnection network (23) coating a surface of the semiconductor substrate, the interconnection network comprising a level (31) of conductive vias (39) in contact, by their lower surface, with the photodetection pixels,
wherein said conductive vias are made of doped polysilicon and **characterized in that** said vias have a heavier doping on their lower surface side than on their upper surface side.

2. Sensor according to claim 1, wherein said conductive vias (39) have a decreasing doping gradient starting from the upper surface of the substrate (25).

3. Image sensor according to claim 1 or 2, wherein the conductive vias (39) are doped with phosphorus or arsenic atoms.

4. Method of manufacturing an image sensor (15) comprising:
- the forming of a plurality of photodetection pixels (19) inside and on top of a semiconductor substrate (25); and
- the forming of a level (31) of conductive vias (39) of an interconnection network (23), the vias (39) being in contact by their lower surface with the photodetection pixels, the conductive vias (39) being made of doped polysilicon and having a heavier doping on their lower surface side than on their upper surface side.

5. Method according to claim 4, wherein said vias (39) have a decreasing doping gradient starting from the upper surface of the substrate.

6. Method according to claim 4 or 5, wherein the forming of the conductive vias (39) comprises a step of forming of openings (65) in an insulating layer (61), in contact with the photodetection pixels (19).

7. Method according to claim 6, wherein the forming of the conductive vias (39) comprises, after the step of forming of the openings (65), the following successive steps:
- forming of an amorphous silicon film (67) on top and inside of the openings (65);
- ex-situ doping of said film (67) by the implantation of dopants; and
- filling of the openings (65) with a amorphous silicon layer (69).

8. Method according to claim 7, wherein at the end of the step of doping of the film (67), said film has a doping in the order of 1.10²¹ at/cm³.

9. Method according to claim 7 or 8, wherein the amorphous silicon of the film (67) is further doped in-situ during its deposition.

10. Method according to any of claims 7 to 9, wherein the silicon of said layer (69) is doped in-situ during its deposition.

11. Method according to claim 6, wherein the forming of the conductive vias (39) comprises, after the step of forming of the openings (65), the following successive steps:
- filling of the openings (65) with an amorphous silicon layer (93); and
- ex-situ doping of said layer (93), in the vicinity of the semiconductor substrate (25), by the implantation of dopants.

12. Method according to claim 11, wherein the silicon of said layer (93) is further doped in-situ during its deposition.

13. Method according to claim 11 or 12, wherein at the end of the step of doping of the layer (93), said layer has a doping, in the vicinity of the substrate (25), in the order of 1.10²¹ at/cm³.

14. Method according to any of claims 6 to 13, comprising, after the forming of the openings (65) in the insulating layer (61) in contact with the photodetection pixels, a step of amorphization of the surface of the substrate (25) and of the surface of polysilicon conductive gates (27) at the bottom of the openings (65).

15. Image acquisition device (11) comprising a first image sensor (13) and a second image sensor (15) according to any of claims 1 to 3, the first image sensor and the second image sensor being stacked.
